Europäisches Patentamt

European Patent Office

Office européen des brevets

(11) Numéro de publication: **0 247 934**
**A1**

## DEMANDE DE BREVET EUROPEEN

(21) Numéro de dépôt: **87401166.1**

(22) Date de dépôt: **22.05.87**

(51) Int. Cl.⁴: **H 01 L 39/14**
**H 01 L 39/24**

(30) Priorité: **22.05.86 FR 8607364**

(43) Date de publication de la demande:
**02.12.87 Bulletin 87/49**

(84) Etats contractants désignés:
**AT BE CH DE ES GB GR IT LI LU NL SE**

(71) Demandeur: **CENTRE NATIONAL DE LA RECHERCHE SCIENTIFIQUE (CNRS)**
**15, Quai Anatole France**
**F-75007 Paris (FR)**

(72) Inventeur: **Chevrel, Roger André Pierre**
**Le Pont**
**F-35630 Vignoc (FR)**

**Sergent, Marcel**
**21 rue des Tilleuls**
**F-35510 Cesson Sevigne (FR)**

**Hirrien, Maryvonne Françoise**
**189B, avenue du Général Leclerc**
**F-35700 Rennes (FR)**

(74) Mandataire: **Nony, Michel et al**
**29, rue Cambacérès**
**F-75008 Paris (FR)**

(54) Brin ou ruban hybride supraconducteur, son procédé de préparation et brins multifilamentaires obtenus par association de tels brins hybrides.

(57) Brin ou ruban hybride supraconducteur comprenant au moins deux couches entourant une âme, caractérisé par le fait que ledit brin ou ruban comprend deux matériaux supraconducteurs, que l'un des matériaux supraconducteurs est une phase de Chevrel éventuellement dopée et constitue l'une des couches ou l'âme et que le second supraconducteur, autre qu'une phase de Chevrel, constitue une autre couche éventuellement lacunaire ou l'âme ; sa préparation ; et brin filamentaire constitué par association de tels brins hybrides.

EP 0 247 934 A1

**Description**

Brin ou ruban hybride supraconducteur, son procedé de préparation et brins multifilamentaires obtenus par association de tels brins hybrides.

La présente invention a pour objet de nouveaux brins ou rubans hybrides supraconducteurs et leur préparation, ainsi que des brins multifilamentaires constitués à l'aide desdits brins hybrides.

On sait que certains métaux possèdent des propriétés supraconductrices à basse température, mais sont difficilement utilisables pour réaliser des aimants car leur état supraconducteur disparaît lorsque le champ magnétique s'élève.

On connaît maintenant divers matériaux supraconducteurs capables de supporter des champs magnétiques intenses.

Parmi ces supraconducteurs, on peut citer par exemple :

- les matériaux du type $M_3M'$,

M représentant au moins un métal choisi parmi le niobium et le vanadium,

et M' représentant au moins un métal choisi parmi l'aluminium, le gallium, le germanium, l'étain, l'indium et le silicium.

Ces matériaux sont généralement désignés par l'appellation "phases A-15" et sont décrits par exemple par D. Dew-Hughes, "Superconducting A-15 compounds : A review" Cryogenics, August 1975, pages 435-454.

- les "phases de Laves" ou "phases C-15" qui sont des composés répondant à la formule $M''V_2$,

M'' étant au moins un métal choisi parmi le hafnium et le zirconium; les phases de Laves et leurs propriétés sont décrites notamment par K. TACHIKAWA, in "Superconductor Materials Science", Edited by Simon Foner and Brian B. Schwartz, Plenum Press (1981) pages 855-856.

- les alliages Nb-Ti (ou alliages de type $A_2$) contenant par exemple de 40 à 55% en poids de titane; ces alliages, qui peuvent en outre contenir d'autres métaux tels que le tantale, le zirconium, etc... et leurs propriétés supraconductrices sont décrits par exemple par D.C. LARBALESTIER, in "Superconducter Materials Science", op. cit., pages 133-199.

- les "phases de Chevrel" qui sont des composés répondant à la formule $M'''_xMo_{6+y}X_8$ où M''' est au moins un métal choisi parmi les métaux alcalins, alcalino-terreux, le cuivre, le zinc, l'argent, le cadmium, le mercure, l'indium, le thallium, l'étain, le plomb, l'aluminium, le gallium, le bismuth, l'antimoine, le scandium, l'yttrium, les lanthanides et les actinides,

x peut varier de 0 à 4,

X représente un chalcogène (soufre, sélénium, tellure),

y représente un écart à la stoechiométrie qui peut varier de 0 à 0,5,

étant entendu qu'une partie des chalcogènes peut être substitué par du brome ou de l'iode.

La concentration x de l'élément M''' dépend notamment de la taille de l'ion de cet élément. Parmi les phases de Chevrel connues on peut citer notamment les composés $PbMo_6S_8$, $SnMo_6S_8$, $Cu_xMo_6S_8$, $Mo_6S_8$, $Mo_6Se_8$, $LaMo_6S_8$, $LaMo_6Se_8$, $AgMo_6S_8$, $TlMo_6Se_8$, $Mo_6S_6Br_2$, $Mo_6S_6I_2$, etc...

En outre, dans les phases de Chevrel, le molybdène peut être partiellement remplacé (par exemple dans des proportions pouvant aller jusqu'à 10% en atomes) par au moins un métal choisi parmi Nb, Ta, W, Re, Ru, Rh, etc...

Les phases de Chevrel peuvent en outre comporter de façon connue, des dopants tels que l'étain, l'aluminium, le niobium, le silicium, le gallium, l'argent, le plomb, etc...

Les phases de Chevrel peuvent être élaborées, de façon connue, au départ des éléments ou composants binaires suivants : soufre, molybdène, métal M''', métaux dopants, et/ou sulfures $M'''S_n$ (n étant un nombre égal à la moitié de la valence de M'''), $MoS_2$ et/ou $Mo_2S_3$ et/ou sulfures des éléments dopants, en proportions convenables pour obtenir la phase de Chevrel de composition voulue appartenant au domaine d'existence des phases de Chevrel dans le diagramme de phase à la température réactionnelle considérée.

Les phases de Chevrel et leurs propriétés supraconductrices sont décrites notamment dans "Topics of Current Physics", volumes 32 et 34, Superconductivity in Ternary Compounds I et II, Edited by Ø. Fischer and M.B. Maple, Springer-Verlag (1982).

Les supraconducteurs à base de phases de Chevrel sont potentiellement intéressants car les courbes de densité de courant critique en fonction du champ appliqué montrent qu'on obtient des valeurs relativement élevées de densité de courant critique, avec une variation extrêmement faible, à haut champ.

Actuellement, les phases A-15, les alliages niobium-titane et les phases de Laves ont des densités de courant plus élevées mais ne sont utilisables qu'à champ moyen.

On sait que les matériaux supraconducteurs sont utilisés notamment sous la forme de rubans ou de fils composites généralement associés en brins multifilamentaires; voir par exemple R. Chevrel et M. Sergent, Innov. Tech. Biol. Med. Vol.n°5, pages 516-526 (1984).

Les brins supraconducteurs individuels comportent généralement une gaine de cuivre, car le cuivre est un bon conducteur de la chaleur et permet d'évacuer facilement la chaleur produite par les brusques transitions à l'état conducteur qui peuvent se produire localement dans les bobines réalisées avec les filaments supraconducteurs.

Pour des utilisations à haut champ, il est encore possible de renforcer le fil par une gaine externe supplémentaire supportant bien les contraintes mécaniques, par exemple en acier inoxydable.

Un inconvénient du cuivre est qu'il a tendance à migrer dans les phases de Chevrel et à en détériorer les propriétés supraconductrices. Aussi, divers essais de protection par une gaine métallique de la phase de Chevrel ont été réalisés.

L'utilisation des supraconducteurs à base de phases de Chevrel pose toutefois des problèmes techniques difficiles à résoudre, car même les brins réalisés avec des gaines ou barrières métalliques séparant la phase de Chevrel de la gaine de cuivre ne se sont pas révélés satisfaisants ; voir par exemple Thomas Luhman et al., J. Appl. Phys. 49 (2), 936-938 (1978).

On a maintenant découvert que les résultats décevants observés avec les composites à base de phases de Chevrel sont dûs en partie à la formation de barrières résistives à l'interface phase de Chevrel-gaine.

Un autre inconvénient des phases de Chevrel est que la densité de courant à bas champ est relativement faible.

La présente invention a pour but de rendre les densités de courant des phases de Chevrel très élevées, même à faible champ, et d'éviter la formation de barrières résistives lors de l'elaboration des brins ou rubans composites.

Cette amélioration a été obtenue par la réalisation d'un brin hybride supraconducteur associant une phase de Chevrel à une autre phase supraconductrice.

La présente invention a donc pour objet un brin ou ruban hybride supraconducteur comprenant au moins deux couches entourant une âme, cacactérisé par le fait que ledit brin ou ruban comprend deux matériaux supraconducteurs, que l'un des matériaux supraconducteurs est une phase de Chevrel éventuellement dopée et constitue l'une des couches ou l'âme et que le second supraconducteur, autre qu'une phase de Chevrel, constitue un autre couche éventuellement lacunaire ou l'âme.

Dans des modes de réalisation particuliers, le brin ou ruban hybride supraconducteur de l'invention peut encore présenter les caractéristiques suivantes, prises isolément ou en combinaison selon les cas :
- l'un des deux matériaux supraconducteurs, par exemple la phase de Chevrel, constitue l'âme ;
- les deux matériaux supraconducteurs sont au contact l'un de l'autre,
- le second matériau supraconducteur est choisi parmi une phase A-15, une phase de Laves ou un alliage du type Nb-Ti;
- le rapport de épaisseurs du second supraconducteur et de la phase de Chevrel est inférieur à 15%.

Bien entendu, lorsque l'une des phases supraconductrices constitue l'âme, l'autre phase supraconductrice constitue l'une des couches entourant l'âme, et l'autre couche obligatoirement présente est soit une barrière entre les deux phases supraconductrices, soit une gaîne externe de cuivre constituant une troisième couche, soit encore une barrière entre la phase supraconductrice la plus externe et une gaîne externe de cuivre constituant une quatrième couche.

L'invention a également pour objet un procédé de préparation d'un brin ou ruban hybride tel que défini précédemment. Ce procédé est principalement caractérisé par le fait que l'on dispose, de façon connue, les couches constitutives du brin ou ruban, étant entendu que l'âme ou les couches supraconductrices contiennent le supraconducteur soit déjà elaboré, soit sous la forme de précurseurs dudit supraconducteur, que l'on procède éventuellement à un compactage, et que, si désiré, on procède aux opérations classiques d'extrusion, d'etirage et de tréfilage ou laminage pour obtenir un brin ou ruban de section réduite, puis que l'on soumet le produit obtenu à un traitement thermique, de façon connue en soi, pour restaurer la supraconductivité et, la cas échéant, élaborer le ou les supraconducteurs.

D'une façon générale, les matériaux utilisés, et en particular les précurseurs des phases supraconductrices, doivent avoir une pureté suffisante. Le taux d'impuretés (et en particulier de métaux magnétiques 3d) doit au moins être inférieur à 100ppm.

Dans des modes de réalisation particuliers, le procédé de l'invention peut encore présenter les caractéristiques suivantes, prises isolément ou en combinaison selon les cas :
- les précurseurs d'un matériau supraconducteur sont répartis dans deux couches adjacentes ou dans l'âme et la couche immédiatement adjacente ;
- on ajoute à la phase de Chevrel ou à ses précurseurs, un des précurseurs de l'autre supraconducteur, les autres précurseurs dudit autre supraconducteur étant présents dans une couche adjacente ou, le cas échéant, dans l'âme adjacente à la phase de Chevrel ;
- on ajoute à la phase de Chevrel, ou à ses précurseurs, un précurseur de l'autre supraconducteur, ce précurseur étant choisi parmi le silicium, l'aluminium, le germanium, le gallium, l'indium, l'étain, le hafnium, le zirconium et le titane, ou éventuellement les sulfures correspondants ;
- un précurseur d'un des supraconducteurs est un précurseur capable de réagir avec une couche adjacente en niobium ou en vanadium, pour former une phase A-15 ; ledit précurseur est choisi par exemple à base de silicium, d'aluminium, de germanium, de gallium, d'indium, ou d'étain ;
- un précurseur d'un supraconducteur est un précurseur capable de réagir avec une couche adjacente de vanadium pour former une phase de Laves; par exemple, ledit précurseur est choisi parmi le hafnium et le zirconium;
- un précurseur d'un supraconducteur est à base de titane qui donne avec une couche adjacente en niobium un alliage du type niobium-titane ;
- ledit brin ou ruban comprend une couche externe constituée d'un alliage cuivre-étain et l'étain réagit avec la couche interne adjacente en niobium pour former une couche supraconductrice $Nb_3Sn$.

D'une façon générale, la phase de Chevrel (ou ses précurseurs) utilisée comme produit de départ et

3

**0 247 934**

éventuellement l'additiff mélangé à la phase de Chevrel, est sous forme de poudre (éventuellement compactée) de granulométrie inférieure à 40 micromètres, et de préférence inférieure à 20 micromètres.

Le traitement thermique effectué en fin de procédé sur le fil ou le ruban obtenu a pour but de restaurer la supraconductivité (dans le cas d'un produit de départ contenant une phase supraconductive, par exemple une phase de Chevrel, déjà formée) et éventuellement d'élaborer la phase supraconductrice (par exemple la phase de Chevrel) par réaction entre les précurseurs de celle-ci. Le fil ou ruban obtenu sera chauffé à température généralement inférieure à 1000°C, notamment entre 600 et 1000°C, en une ou plusieurs étapes. La température choisie dépend de la nature du mélange de départ, de l'additif, et de la barrière. Le temps de chauffage peut être déterminé expérimentalement de façon simple, dans chaque cas, en choisissant la durée qui donne les meilleures propriétés supraconductrices du fil ou ruban préparé.

On va maintenant décrire plus en détail, à titre d'illustration seulement, un mode de réalisation du procédé de l'invention consistant à former une phase supraconductrice au contact d'une phase de Chevrel.

Le procédé de l'invention présente de nombreux avantages, notamment dans le cas où l'on provoque la formation in situ d'une seconde phase supraconductrice à l'interface de la phase de Chevrel et de la couche adjacente. On a constaté que même si la seconde phase supraconductrice est lacunaire, c'est-à-dire si le film supraconducteur ne recouvre pas entièrement la phase de Chevrel, on obtient déjà des améliorations intéressantes de la densité de courant critique.

Selon un mode de réalisation particulier, pour réaliser la seconde couche supraconductrice à la surface de la phase de Chevrel, on mélange la phase de Chevrel (ou ses précurseurs) sous forme de poudre, avec un additif, également sous forme de poudre, qui est un des précurseurs de la seconde phase supraconductrice que l'on veut élaborer. Bien entendu, les mélanges de poudres doivent être homogènes. Toutefois, l'additif peut n'être appliqué qu'à l'interface phase de Chevrel-barrière.

L'additif, précurseur de la seconde phase supraconductrice, est ajouté à la phase de Chevrel par exemple sous la forme de l'élément lui-même, ou sous la forme du sulfure correspondant, et dans ce dernier cas la composition des précurseurs de la phase de Chevrel devra tenir compte du soufre supplémentaire apporté par l'additif, étant donné que, comme cela est bien connu des spécialistes, tout excès de soufre dans la phase de Chevrel est généralement nuisible.

Il faut remarquer que la possibilité d'obtenir une phase supraconductrice par diffusion d'un précurseur et réaction ou mélange avec d'autres précurseurs présents dans une couche adjacente constitue une caractéristique inattendue du procédé de l'invention. Par exemple, dans le cas d'une phase de Chevrel qui contient un additif précurseur (tel que l'étain) d'une phase A-15 et qui est entourée d'une gaîne de niobium, on a effectivement observé qu'il se forme à l'interface un film de composition définie $Nb_3Sn$ (phase A-15) malgré la présence d'un excès de niobium; autrement dit, on obtient dans ce cas un composite ayant la structure suivante : phase de Chevrel/phase A-15/niobium.

On aurait pu s'attendre à ce que le niobium diffuse dans la phase de Chevrel et forme à l'interface par exemple, un sulfure de niobium constituant une barrière résistive indésirable.

Bien entendu, on peut aussi choisir l'épaisseur de la barrière de niobium et la quantité d'étain dans la phase de Chevrel de façon que les proportions de Nb et d'étain correspondent sensiblement à la composition $Nb_3Sn$ et dans ce cas le composite obtenu aura la structure phase de Chevrel/phase A-15 sans que demeure de façon appréciable une barrière de niobium en excès. Il faut noter que la présence d'une barrière de niobium dans le composite final ne nuit pas aux propriétés supraconductrices et peut même s'avérer intéressante car elle s'oppose à la diffusion du cuivre de la gaîne externe vers la phase de Chevrel.

Un avantage du procédé de l'invention est donc de permettre la formation in situ, à l'interface phase de Chevrel-barrière métallique, d'une phase supraconductrice (A-15, phase de Laves, alliage du type Nb-Ti).

L'intérêt est notamment d'obtenir une interface très "propre", sans pollution ni oxydation de la barrière par le soufre, et ainsi de réaliser une véritable barrière "active". En outre, l'additif, en particulier lorsqu'il s'agit d'un métal à bas point de fusion, permet de fritter les grains de poudre de phase de Chevrel entre eux, et d'assurer ainsi un très bon contact électrique. Par ailleurs, dans le cas où l'additif est plus oxydable que les constituants de la phase de Chevrel, il permet de purifier la phase de Chevrel par piégeage de l'oxygène, adsorbé à la surface des poudres, sous forme d'oxydes qui créeront entre les grains de la phase de Chevrel des centres d'ancrage des lignes de flux. L'intérêt de tels centres d'ancrage est bien connu (voir par exemple l'article de Chevrel et Sergent déjà cité plus haut).

Tous ces avantages du procédé de l'invention permettent d'obtenir des fils ou rubans composites supraconducteurs ayant des caractéristiques exceptionnelles, et rendent pour la première fois possible l'utilisation industrielle des phases de Chevrel dont l'intérêt, jusqu'à présent, était surtout théorique.

L'invention concerne également l'utilisation comme additif, dans une phase de Chevrel, ou dans un mélange de précurseurs d'une phase de Chevrel, d'un élément ou sulfure choisi pour être un précurseur d'une phase supraconductrice. L'additif est choisi, comme décrit ci-dessus, de façon à permettre d'élaborer in situ, à l'interface de la phase de Chevrel et d'une barrière convenablement choisie, une phase supraconductrice autre qu'une phase de Chevrel. La quantité d'additif sera ajustée en fonction de ce qui est souhaité, c'est-à-dire la transformation totale, ou seulement partielle, de la barrière en phase supraconductrice.

L'invention a également pour objet un brin multifilamentaire caractérisé par le fait qu'il est constitué d'un ensemble de brins hybrides tels que définis précédemment. Ces brins multifilamentaires sont préparés de façon connue.

Les exemples suivants illustrent l'invention sans toutefois la limiter.

4

EXEMPLE 1

On mélange des poudres de précurseurs d'une phase de Chevrel, contenant les constituants suivants (proportions molaires):

1,05 Pbs ; 0,2 SnS ; 3,375 $MoS_2$ ; 2,925 Mo

L'additif est le sulfure d'étain.

Les poudres ont une granulométrie inférieure à 20 micromètres.

On a vérifié que ce mélange permet d'obtenir à température convenable la phase de Chevrel ayant la composition $Pb_{1,05} Mo_{6,3} S_8$, avec comme additif 0,2 Sn.

Le mélange de poudres, non pré-réagi, est tassé dans un tube de niobium de diamètre intérieur 6mm et de diamètre extérieur 12mm. Ledit cylindre est lui-même inséré dans un tube (appelé billette) de cuivre de diamètre intérieur 12mm et de diamètre extérieur 14mm.

On scelle la billette sous vide.

Par extrusion, étirage et tréfilage à froid selon les méthodes classiques, on prépare avec cet ensemble composite un fil de diamètre 0,5mm.

Ce fil est soumis à un traitement thermique à 950°C pendant 4 heures de façon à permettre l'élaboration de la phase de Chevrel, et de la phase A-15 ($Nb_3$ Sn) à l'interface phase de Chevrel-niobium.

Les propriétés du fil obtenu sont les suivantes (selon la méthod résistive), par comparaison avec un fil obtenu de façon analogue mais sans addition d'étain à la phase de Chevrel (Tableau 1).

TABLEAU 1

| Champ appliqué (Tesla) | Densité de courant critique ($A/m^2$) | |
|---|---|---|
| | avec addition d'étain | sans addition d'étain |
| 3 | $4,5 . 10^8$ | $7 . 10^7$ |
| 7 | $2,7 . 10^8$ | $3,4 . 10^7$ |
| 9,2 | $2 . 10^8$ | $2,5 . 10^7$ |

Ces résultats sont susceptible d'être améliorés en procédant à un compactage de la poudre de départ, qui était simplement tassée dans le cas présent.

On a vérifié qu'il y avait bien formation de phase A-15 ($Nb_3Sn$) à l'interface phase de Chevrel-niobium.

Un essai de détermination de la densité de courant critique selon la méthode résistive, avec un champ appliqué de 20 Tesla, a montré que la densité de courant critique était de l'ordre de $10^8 A/m^2$.

EXEMPLE 2

Le mélange de poudres de départ (précurseurs de la phase de Chevrel + additif) a ici la composition suivante:

1,4 SnS ; 3,3 $MoS_2$ ; 3 Mo

Ce mélange permet d'obtenir la phase de Chevrel de composition Sn $Mo_{6,3} S_8$, avec comme additif 0,4 Sn.

On a préparé un fil composite de diamètre 0,3mm, de façon analogue à celle décrite à l'exemple 1.

Le traitement thermique consistait ici en un traitement à 750°C pendant 44 heures suivi d'un traitement à 900°C pendant 15heures.

Les caractéristiques du fil obtenu sont les suivantes (Tableau 2).

TABLEAU 2

| Champ appliqué en Tesla | Densité de courant critique $(A/m^2)$ |
|---|---|
| 3 | $2,7.10^8$ |
| 7 | $1,7.10^8$ |
| 9,2 | $1,3.10^8$ |

## EXEMPLE 3

De façon analogue, en partant d'un mélange de précurseurs d'une phase de Chevrel avec l'additif titane, avec une barrière de niobium, le tout étant inséré dans une gaine de cuivre, on a obtenu un fil composite avec formation à l'interface phase de Chevrel-niobium d'un film supraconducteur d'alliage Nb-Ti.

## EXEMPLE 4

De façon analogue, au départ d'un mélange de précurseurs d'une phase de Chevrel contenant comme additif du zirconium, avec une barrière de vanadium, le tout étant inséré dans une gaine de cuivre, on a obtenu un fil composite avec formation à l'interface phase de Chevrel-vanadium, d'une phase de Laves $ZrV_2$.

## Revendications

1. Brin ou ruban hybride supraconducteur comprenant au moins deux couches entourant une âme, caractérisé par le fait que ledit brin ou ruban comprend deux matériaux supraconducteurs, que l'un des matériaux supraconducteurs est une phase de Chevrel éventuellement dopée et constitue l'une des couches ou l'âme et que le second supraconducteur, autre qu'une phase de Chevrel, constitue une autre couche éventuellement lacunaire ou l'âme.

2. Brin ou ruban hybride supraconducteur selon la revendication 1, caractérisé par le fait que l'un des matériaux supraconducteurs constitue l'âme.

3. Brin ou ruban hybride selon l'une quelconque des revendications 1 et 2, caractérisé par le fait que les deux matériaux supraconducteurs sont au contact l'un de l'autre.

4. Brin ou ruban hybride selon l'une quelconque des revendications précédentes, caractérisé par le fait que la phase de Chevrel constitue l'âme.

5. Brin ou ruban hybride selon l'une quelconque des revendications précédentes, caractérisé par le fait que ledit matériau supraconducteur autre qu'une phase de Chevrel est un phase A-15, une phase de Laves ou un alliage du type Nb-Ti.

6. Procédé de préparation d'un brin ou ruban hybride selon l'une quelconque des revendications précédentes, caractérisé par le fait que l'on dispose, de façon connue, les couches constitutives du brin ou ruban, étant entendu que l'âme ou les couches supraconductrices contiennent le supraconducteur soit déjà élaboré, soit sous la forme de précurseurs dudit supraconducteur, que l'on procède éventuellement à un compactage, et que, si désiré, on procède aux opérations classiques d'extrusion, d'étirage et de tréfilage ou laminage pour obtenir un brin ou ruban de section réduite, puis que l'on soumet le produit obtenu à un traitement thermique, de façon connue en soi, pour restaurer la supraconductivité et, le cas échéant, élaborer le ou les supraconducteurs.

7. Procédé selon la revendication 6, caractérisé par le fait que les précurseurs d'un matériau supraconducteur sont répartis dans deux couches adjacentes ou dans l'âme et la couche immédiatement adjacente.

8. Procédé selon l'une quelconque des revendications 6 et 7, caractérisé par le fait que l'on ajoute à la phase de Chevrel, ou à ses précurseurs, un des précurseurs de l'autre supraconducteur, les autres précurseurs dudit autre supraconducteur étant présents dans une couche adjacente ou, le cas échéant, dans l'âme adjacente à la phase de Chevrel.

9. Procédé selon la revendication 8, caractérisé par le fait que l'on ajoute à la phase de Chevrel, ou à

**0 247 934**

ses précurseurs, un précurseur de l'autre supraconducteur contentant un élément choisi parmi le silicium, l'aluminium, le germanium, le gallium, l'indium, l'étain, le hafnium, le zirconium et le titane, ou les sulfures de ces éléments.

10. Procédé selon l'une quelconque des revendications 7 à 9, caractérisé par le fait qu'un précurseur d'un des supraconducteurs est un précurseur capable de réagir avec une couche adjacente en niobium on en vanadium, pour former une phase A-15.

11. Procédé selon la revendication 10, caractérisé par le fait que ledit précurseur est à base de silicium, d'aluminium, de germanium, de gallium, d'indium ou d'étain.

12. Procédé selon l'une quelconque des revendications 7 à 9, caractérise par le fait qu'un précurseur d'un supraconducteur est un précurseur capable de réagir avec une couche adjacente de vanadium pour former une phase de Laves.

13. Procédé selon la revendication 12, caractérisé par le fait que ledit précurseur est choisi parmi le hafnium et le zirconium.

14. Procédé selon l'une quelconque des revendications 7 à 9, caractérisé par le fait qu'un précurseur d'un supraconducteur est à base de titane et qu'il donne avec une couche adjacente en niobium un alliage du type niobium-titane.

15. Procédé selon la revendication 7, caractérisé par le fait que ledit brin ou ruban comprend une couche externe constituée d'un alliage cuivre-étain et que l'étain réagit avec la couche interne adjacente en niobium pour former une couche supraconductrice $Nb_3Sn$.

16. Brin multifilamentaire, caractérisé par le fait qu'il est constitué d'un ensemble de brins hybrides tels que définis dans l'une quelconque des revendications 1 à 5.

7

## DOCUMENTS CONSIDERES COMME PERTINENTS

| Catégorie | Citation du document avec indication, en cas de besoin. des parties pertinentes | Revendication concernée | CLASSEMENT DE LA DEMANDE (Int Cl.4) |
|---|---|---|---|
| X | EP-A-0 138 719 (ALSTHOM-ATLANTIQUE) * Page 1, ligne 13; revendication 1 * | 1 | H 01 L 39/14 H 01 L 39/24 |
| | --- | | |
| A | EP-A-0 171 918 (MITSUBISHI) | | |
| | --- | | |
| A | PHYSICAL REVIEW B CONDENSED MATTER, vol. 29, no. 1, 1er janvier 1984, pages 172-180, The American Physical Society, New York, US; J.M. TARASCON et al.: "New superconducting ternary molybdenum chalcogenides $InMo_6Se_8$,$TlMo_6S_8$, and $TlMo_6Se_8$" | | |
| | ----- | | |

**DOMAINES TECHNIQUES RECHERCHES (Int. Cl.4)**

H 01 L 39/14
H 01 L 39/24
H 01 L 39/12

Le présent rapport de recherche a été établi pour toutes les revendications

| Lieu de la recherche | Date d'achèvement de la recherche | Examinateur |
|---|---|---|
| LA HAYE | 31-08-1987 | PELSERS L. |